# EUROPÄISCHE PATENTSCHRIFT

(11) **EP 1 959 149 B1**
(45) Veröffentlichungstag und Bekanntmachung des Hinweises auf die Patenterteilung: **08.04.2015**
(21) Anmeldenummer: 08002728.7
(22) Anmeldetag: 14.02.2008
(51) Int. Cl.: F16C 32/06, G03F 7/20

(54) **Luftlager mit Berücksichtigung hochfrequenter Resonanzen**
Air bearing taking high frequency resonances into account
Coussinet d'air prenant en compte les résonances haute fréquence

(30) Priorität: 14.02.2007 DE 102007007909
(43) Veröffentlichungstag der Anmeldung: 20.08.2008
(73) Patentinhaber: Integrated Dynamics Engineering GmbH, 65479 Raunheim (DE)
(72) Erfinder: Heiland, Peter, 65479 Raunheim (DE)
(74) Vertreter: Herden, Andreas F.

(56) Entgegenhaltungen:
- EP-A- 1 803 965
- WO-A-99/05573
- US-A1- 2004 001 188
- US-A1- 2004 065 517

## Beschreibung

Die Erfindung betrifft ein Luftlager.

### Hintergrund der Erfindung

Luftlager zur Schwingungsisolation sind bekannt. So zeigt die europäische Patentanmeldung "Isolatorgeometrie eines Schwingungsisolationssystems" mit der Offenlegungsnummer EP 1 803 965 (Anmeldenummer) 06 026 425.6 ein Luftlager mit erhöhter Tragkraft. Die WO 99/05573 zeigt ein Luftlager gemäß dem Oberbegriff des Anspruchs 1.

Luftlager dieses Typs weisen ein mechanisches Kopplungselement zwischen vertikalem Kolben und Kolbenplatte bzw. der Traglast auf. Damit wird erreicht, dass zwar vertikale Kräfte an die Kolbenplatte übertragen werden, horizontale Kräfte jedoch im Wesentlichen nicht. Ebenfalls werden Änderungen in der Parallelität der Kolbenplatte zur Grundplatte nicht übertragen, was die Verkippung der Isolatorkolben ineinander verhindert.

Bekannte Schwingungsisolationssysteme nach dem Prinzip des Luftlagers sind ohne Berücksichtigung von isolatorinternen Strukturresonanzen für einen Frequenzbereich bis etwa 100Hz (max. 300Hz) ausgelegt. Im Zuge der weiteren Auflösungs- und Präzisionssteigerung von Lithographiemaschinen, Steppern und Immersionssystemen werden jedoch die Frequenzcharakteristiken oberhalb von 300Hz immer bedeutsamer. Daher ist es wichtig, das Frequenzverhalten des Luftlagers selbst zu optimieren, um eine Isolationswirkung auch oberhalb von 300Hz aufrechterhalten zu können. Neben anderen Effekten, die bei Luftlagern des Standes der Technik eine Rolle spielen, kommt dem mechanischen Kopplungselement eine zentrale Rolle zu. Zum einen lastet auf ihm das zu tragende Gewicht und zum anderen ist es das einzige Element zwischen zu tragender Last und dem Isolator. Das in der Kolbenplatte (oben) verschraubte Element kann im Vergleich zum unteren, im vertikalen Kolben des Luftlagers verschraubte Element vernachlässigt werden, da es deutlich kürzer ist. Das untere Element (Pin genannt) bietet eine mechanische Steifigkeit, die vom verwendeten Material, der Länge des Pins, der Gewindedicke der Verschraubung und der Auflagefläche der Verschraubung abhängt. Sie ist bei bekannten Luftlagern so ausgelegt, dass sie für den statischen Belastungsfall ausreichende Festigkeit besitzt, ist aber insbesondere nicht für dynamische Steifigkeiten und Resonanzen ausgelegt.

Bei bekannten Luftlagern kann eine Verbiegung des Pins hervorgerufen werden, die zusammen mit dem Kolben und dem Luftpolsters zum Horizontallager ein schwingfähiges System bilden, deren Eigenfrequenzen zumeist oberhalb von 300Hz liegen. Eine verschlechterte Isolationswirkung in Frequenzbereichen von über 300 Hz ist die Folge.

Es hat sich gezeigt, dass sich dieser Effekt durch eine Änderung der Systemparameter "aufliegende Masse" und "Luftpolster zum Horizontallager" nur bedingt reduzieren lässt.

Das Dokument US 2004/0065517 A1 zeigt mechanisches Lager mit niedriger lateraler Steifigkeit, dabei erfolgt die Schwingungsisolation über federnd gelagerte Pendel. Das Dokument US 2004/0001188 A1 zeigt ein Lithografiegerät mit einem Schwerkraftkompensator, der eine gasgefüllte Druckhammer umfasst.

### Aufgabe der Erfindung

Der Erfindung liegt demgegenüber die Aufgabe zugrunde, die vorstehend genannten Nachteile zumindest zu reduzieren.

Insbesondere ist Aufgabe der Erfindung, einen Pin derart auszulegen, dass er die mechanische Festigkeit für die statische Belastung erfüllt und gleichzeitig eine dynamische Steifigkeit derart aufweist, dass die Eigenresonanzen des Systems "Pin+Kolben" minimiert sind.

### Zusammenfassung der Erfindung

Die Aufgabe der Erfindung wird bereits durch ein Luftlager nach dem unabhängigen Anspruch erreicht.

Danach ist ein vertikal und horizontal wirksames Luftlager vorgesehen, welches eine Basisplatte, ein Zwischenteil, das auf der Basisplatte beweglich angeordnet ist, einen Kolben, der innerhalb des Zwischenteils beweglich angeordnet ist und eine Last trägt, die gegenüber der Basisplatte in horizontaler und vertikaler Richtung schwingungsisoliert gestützt wird und ein Kopplungselement aufweist, welches den Kolben mit der Last verbindet, wobei des Kopplungselement vorzugsweise einen Stift, auch als "Pin" bezeichnet, umfasst, der mit dem Kolben verbunden ist, insbesondere in den Kolben geschraubt ist.

Gemäß der Erfindung ist das Kopplungselement, welches den Kolben mit der Last verbindet, mindestens ein Viertel der, vorzugsweise die halbe Kolbenlänge von der Last beabstandet.

Dieses Ausführungsform der Erfindung bildet also einen anderen Ansatz, bei welcher nicht die Resonanz in Frequenzbereiche geschoben wird, welche für das Gesamtsystem irrelevant sind, sondern in welchem die am Kopplungselement übertragenen Kräfte in ihrer Wirkebene so verschoben sind, dass der Kolben nicht mehr zur Verkippung neigt und damit nicht mehr eine schwingfähige mechanische Impedanz bildet.

Dies gelingt in überraschend einfacher Weise dadurch, dass das Kopplungselement derart ausgebildet ist, dass die Verbindung von Kolben und Last um mindestens ein Viertel der Kolbenlänge von der Last beabstandet ist.

Die vorzugsweise über einen Stift oder eine Schraubverbindung hergestellte Verbindung wird also nach unten in den Kolben verlegt, wodurch die Kippneigung des Kolbens beseitigt wird.

Das Kopplungselement weist eine sich von oben durch den Kolben erstreckende und vorzugsweise im Wesentlichen pyramiden- oder kegelförmig ausgebildete Verlängerung auf, welche mit dem Kolben verbunden ist. Vorzugsweise verjüngt sich der Durchmesser der Durchmesser der Verlängerung in Richtung der Basisplatte.

Unter im Wesentlichen "pyramiden- oder kegelförmig ausgebildet" werden auch Verlängerungen verstanden, welche keinen vollständigen Kegel bilden, sondern beispielsweise aus einzelnen voneinander beabstandeten Segmenten bestehen.

Der Durchmesser der Verlängerung, welcher sich bevorzugt in Richtung der Basis verlängert, bezieht sich nicht zwangsläufig auf eine Verlängerung mit kreisförmigem Querschnitt, sondern die Verlängerung kann auch einen polygonförmigen, insbesondere quadratischen Querschnitt aufweisen.

Gemäß der Erfindung ist an der Last eine weitere Verlängerung angebracht, die mit dem Kopplungselement verbunden ist.

Diese weitere Verlängerung verläuft vorzugsweise innerhalb der ersten Verlängerung und verjüngt sich ebenfalls in Richtung der Basis.

Eine Ausführungsform betrifft ebenfalls ein vertikal und horizontal wirksames Luftlager mit einer Basisplatte, einem Zwischenteil, das auf der Basisplatte beweglich angeordnet ist und einem Kolben, der innerhalb des Zwischenteils beweglich angeordnet ist und die Last trägt, welche gegenüber der Basisplatte in horizontaler und vertikaler Richtung schwingungsisoliert gestützt wird. Dabei verbindet ein Kopplungselement den Kolben mit der Last, wobei des Kopplungselement einen Stift (Pin) aufweist, der mit dem Kolben verbunden ist, insbesondere in den Kolben geschraubt ist.

Die Erfinder haben herausgefunden, dass durch die Auswahl eines Stiftes mit einem Verhältnis von Länge zu Durchmesser von unter 0,7, bevorzugt von unter 0,5 und besonders bevorzugt von unter 0,2 resonanzbedingte Verringerungen der Isolationswirkung in Frequenzbereichen von über 300 Hz weitgehend vermieden werden.

Das Verhältnis "aufliegende Masse" zur Steifigkeit des Pins scheint dabei maßgebend für die zu erwartende Strukturresonanz des Gesamtsystems Luftlager. Je kleiner dieses Verhältnis ist, desto weniger Strukturresonanzen sind zu erwarten und damit besser für künftige Anforderungen gerüstet ist der Isolator.

Alternativ oder in Kombination wird ein Stift verwendet, der einen Durchmesser von mindestes 30, vorzugsweise mindestens 35 und besonders bevorzugt 40 mm aufweist.

Der Stift hat eine Länge von unter 18, bevorzugt von unter 10 und besonders von unter 6 mm.

Weiter weist der Stift vorzugsweise ein Gewinde auf, wobei das Verhältnis vom Durchmesser des Gewindes zur Länge des Kolbens mehr als 0,8, bevorzugt mehr als 1,5 und besonders bevorzugt mehr als 3 beträgt. Insbesondere hat das Gewinde einen Durchmesser von über 10, bevorzugt über 15 und besonders bevorzugt über 20 mm aufweist

Zur Erhöhung der Steifigkeit ist der Stift vorzugsweise aus Stahl, Titan oder einer entsprechenden Legierung ausgebildet.

### Kurzbeschreibung der Zeichnungen

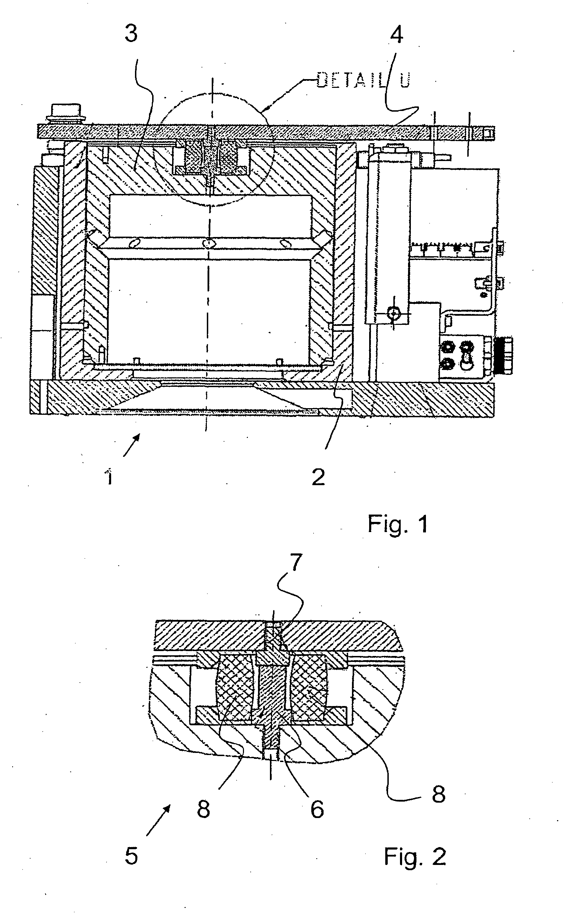

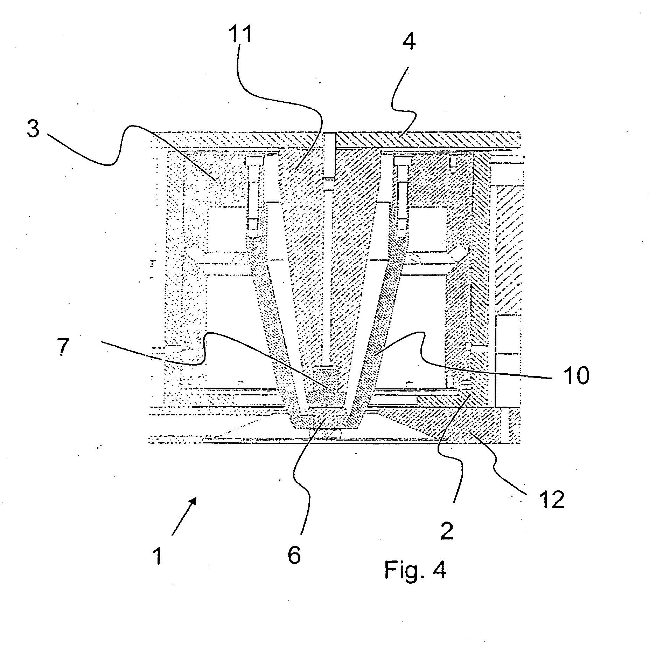

Die Erfindung soll im Folgenden anhand der Zeichnungen Fig. 1 bis Fig. 6 näher erläutert werden.
Fig. 1 bis Fig. 3 zeigen Schnittansichten einer Ausführungsform, bei welcher die Geometrie des Stiftes des Kopplungselementes optimiert ist,
Die Figuren Fig. 4 bis Fig. 6 zeigen eine Ausführungsform der Erfindung, bei welcher das Kopplungselement in etwa auf Höhe der Basisplatte angeordnet ist.

### Detaillierte Beschreibung der Zeichnungen

Fig. 1 zeigt ein Luftlager 1. Das Luftlager, welches in der in der Einleitung zitierten Patentanmeldung näher beschrieben ist, umfasst unter anderem ein Zwischenteil 2, in welchem ein Kolben 3 schwingungsisoliert gelagert ist. Die zu isolierende Last 4 ist mit dem Kolben 3 über ein Kopplungselement (DETAIL U) verbunden.

Fig. 2 zeigt eine Detailansicht des Kopplungselementes 5. Das Kopplungselement umfasst einen unteren Stift 6, welcher in den Kolben (3 aus Fig. 1) geschraubt ist, sowie einen oberen Stift, welcher in die zu isolierende Last bzw. die Kolbenplatte (4 aus Fig. 1) geschraubt ist. Weiter umfasst das Kopplungselement einen Gummipuffer 8 als Federelement, der im Wesentlichen ringförmig ausgebildet ist. Der obere Stift 7 liegt auf dem unteren Stift 6 auf.

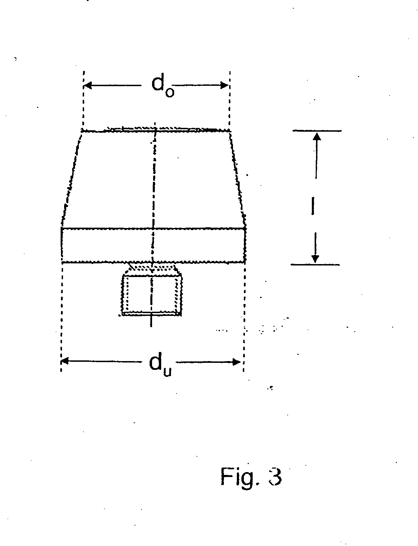

Fig. 3 zeigt eine schematische Ansicht eines unteren Stiftes 6. Der Stift ist im Wesentlichen zylinderförmig ausgebildet, wobei er im oberen Bereich leicht angeschrägt ist. Daher hat der Stift einen oberen Durchmesser dₒ, welcher kleiner ist, als der untere Durchmesser dᵤ. Die Angaben zum Durchmesser können sowohl auf den unteren, als auch den oberen Durchmesser bezogen sein. Der Stift hat die Länge 1, in welche die Länge des Gewindes 6 nicht eingeht.

Die Erfinder haben herausgefunden, dass sich resonanzbedingte Störungen im Bereich von über 300 Hz durch die beanspruche Auswahl von Länge zu Durchmesser reduzieren oder weitgehend vermeiden lassen.

Weiter weist der Stift 6 ein Gewinde 9 zum Einschrauben des Stiftes in den Kolben (3 aus Fig. 1) auf. Das Gewinde hat vorzugsweise einen Durchmesser von über 20 mm, insbesondere ist es als M24 oder M30 Gewinde ausgebildet.

Fig. 4 zeigt eine schematische Schnittansicht der Erfindung, bei welcher das Kopplungselement, welches den Berührpunkt zwischen Kolben 3 und Last 4 definiert, in Richtung der Basis 12 verschoben wurde.

Dazu weist das Luftlager 1 eine erste Verlängerung 10 auf, welche an der Oberseite mit dem Kolben 3 verbunden, hier verschraubt, ist und sich im Wesentlichen bis zur Basis 12 des Luftlagers 1 erstreckt.

Die erste Verlängerung 10 ist in diesem Ausführungsbeispiel im Wesentlichen als Hohlzylinder ausgebildet.

An der Last angebracht ist eine weitere Verlängerung 11, welche sich innerhalb der ersten Verlängerung 10 nach unten hin erstreckt.

So wird der Berührpunkt zwischen erster 10 und zweiter 11 Verlängerung und damit zwischen Last 4 und Kolben 3, welcher letztendlich durch das zwischen unterem Stift 6 und oberem Stift 7 gebildete Kopplungselement definiert wird, nach unten in Richtung des Basisteils 12 verschoben.

Die weitere Verlängerung 11 ist oben mit der Last fest verschraubt.

Durch die Verlegung des Berührpunktes zwischen unterem Stift 6 und oberem Stift 7 wird die Neigung zur Verkippung des Kolbens 3 derart reduziert, dass störende Eigenfrequenzen weitgehend elimiert sind.

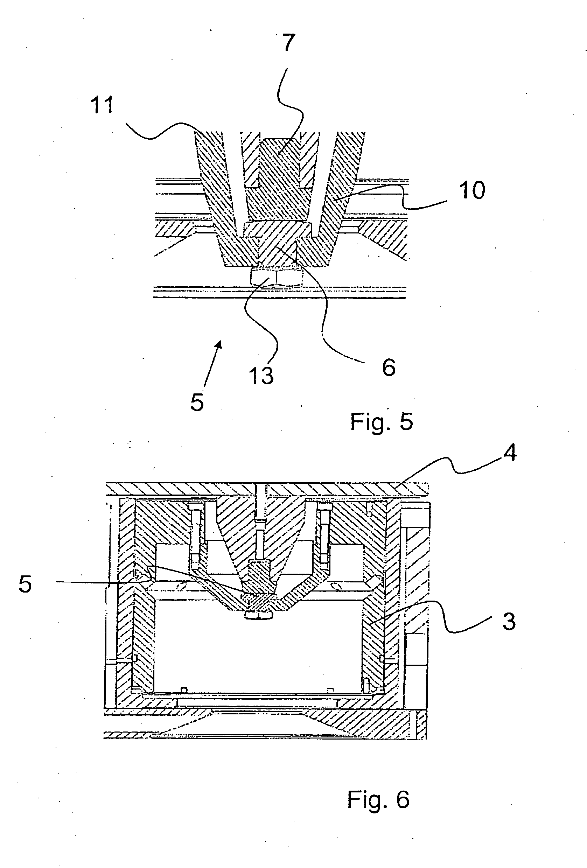

Fig. 5 zeigt eine Detailansicht des Kopplungselementes 5 aus Fig. 4.

Das Kopplungselement 5 besteht in diesem Ausführungsbeispiel aus unterem 6 und oberem Stift 7, welche mittels eines Gewindes (nicht dargestellt) und einer Mutter 13 mit der ersten Verlängerung 10 und der zweiten Verlängerung 11 verschraubt sind.

Erster und/oder zweiter Stift 6, 7 können, um den Durchtritt von Schwingungen zu reduzieren, aus elastischem Material ausgebildet sein.

Fig. 6 zeigt eine weitere Ausführungsform, bei der das Kopplungselement 5 etwas weiter unten in Richtung der Last 4 angeordnet ist, als in der Ausführungsform gemäß Fig. 4. Hier befindet sich das Kopplungselement 5 etwa auf der Hälfte der Länge des Kolbens 3.

### Bezugszeichenliste

- 1: Luftlager
- 2: Zwischenteil
- 3: Kolben
- 4: Last
- 5: Kopplungselement
- 6: unterer Stift
- 7: oberer Stift
- 8: Gummipuffer
- 9: Gewinde
- 10: Verlängerung
- 11: Verlängerung
- 12: Basis
- 13: Mutter

## Patentansprüche

1. Vertikal und horizontal wirksames Luftlager (1), umfassend
- eine Basisplatte;
- ein Zwischenteil (2), das auf der Basisplatte beweglich angeordnet ist;
- einen Kolben (3), der innerhalb des Zwischenteils (2) beweglich angeordnet ist und eine Last (4) trägt, die gegenüber der Basisplatte in horizontaler und vertikaler Richtung schwingungsisoliert gestützt wird;
- ein Kopplungselement (5), welches den Berührpunkt zwischen Kolben (3) und Last (4) definiert und den Kolben (3) mit der Last (4) verbindet;
**dadurch gekennzeichnet, daß**
das Kopplungselement (5) einerseits über eine sich von oben durch den Kolben (3) erstreckende Verlängerung (10) mit dem Kolben (3) und andererseits über eine sich in Richtung Basis erstreckende weitere Verlängerung (11), die an der Last (4) angebracht ist, mit der Last (4) verbunden ist und wobei das Kopplungselement (5) von der Last (4) um mindestens ein Viertel der Kolbenlänge beabstandet ist.

2. Vertikal und horizontal wirksames Luftlager nach Anspruch 1, **dadurch gekennzeichnet, dass** das Kopplungselement (5) einen Stift (6) aufweist, der mit dem Kolben (3) verbunden ist, insbesondere in den Kolben (3) geschraubt ist.

3. Vertikal und horizontal wirksames Luftlager nach Anspruch 1 oder 2, **dadurch gekennzeichnet, dass** Verbindung von Kolben (3) und Last (4) von der Last um mindestens ein Drittel, vorzugsweise die Hälfte, und besonders bevorzugt zwei Drittel der Kolbenlänge beabstandet ist.

4. Vertikal und horizontal wirksames Luftlager nach einem der vorstehenden Ansprüche, **dadurch gekennzeichnet, dass** der Stift (6) in etwa an die Basisplatte angrenzt.

5. Vertikal und horizontal wirksames Luftlager nach einem der vorstehenden Ansprüche, **dadurch gekennzeichnet, dass** die Verlängerung im Wesentlichen .pyramiden- oder kegelförmig ausgebildet ist.

6. Vertikal und horizontal wirksames Luftlager nach einem der vorstehenden Ansprüche, **dadurch gekennzeichnet, dass** sich der Durchmesser der Verlängerung (10) in Richtung der Basis (12) verringert.

7. Vertikal und horizontal wirksames Luftlager nach einem der vorstehenden Ansprüche , **dadurch gekennzeichnet, dass** sich der Durchmesser der weiteren Verlängerung (11) in Richtung der Basis (12) verringert.

8. Vertikal und horizontal wirksames Luftlager nach einem der vorstehenden Ansprüche, **dadurch gekennzeichnet, dass** die weitere Verlängerung (11) in der an dem Kolben (3) angeordneten Verlängerung (10) angeordnet ist.

## Claims

1. Vertically and horizontally acting air bearing (1) comprising
- a base plate;
- an intermediate part (2) which is movably arranged on the base plate;
- a piston (3) which is movably arranged inside the intermediate part (2) and bears a load (4) which is supported in a vibration-isolated manner in the horizontal and vertical directions with respect to the base plate;
- a coupling element (5) which defines the contact point between the piston (3) and the load (4) and connects the piston (3) to the load (4);
**characterised in that**
the coupling element (5) is connected on the one hand to the piston (3) by means of an extension (10) extending through the piston (3) from above, and is connected on the other hand to the load (4) by means of a further extension (11) which extends in the direction of the base and is attached to the load (4), and wherein the coupling element (5) is spaced apart from the load (4) by at least one quarter of the piston length.

2. Vertically and horizontally acting air bearing as claimed in claim 1, **characterised in that** the coupling element (5) comprises a pin (6) which is connected to the piston (3), in particular is screwed into the piston (3).

3. Vertically and horizontally acting air bearing as claimed in claim 1 or 2, **characterised in that** the connection of the piston (3) and load (4) is spaced apart from the load by at least one third, preferably half, and particularly preferably two thirds, of the piston length.

4. Vertically and horizontally acting air bearing as claimed in any one of the preceding claims, **characterised in that** the pin (6) approximately adjoins the base plate.

5. Vertically and horizontally acting air bearing as claimed in any one of the preceding claims, **characterised in that** the extension is substantially pyramid-shaped or conical.

6. Vertically and horizontally acting air bearing as claimed in any one of the preceding claims, **characterised in that** the diameter of the extension (1) decreases towards the base (12).

7. Vertically and horizontally acting air bearing as claimed in any one of the preceding claims, **characterised in that** the diameter of the further extension (11) decreases towards the base (12).

8. Vertically and horizontally acting air bearing as claimed in any one of the preceding claims, **characterised in that** the further extension (11) is arranged in the extension (10) arranged on the piston (3).

## Revendications

1. Palier d'air (1) à action verticale et horizontale, comprenant
- une plaque de base ;
- une pièce intercalaire (2), disposée de manière à être mobile sur la plaque de base ;
- un piston (3) disposé de manière à être mobile à l'intérieur de la pièce intercalaire (2) et supportant une charge (4), laquelle est soutenue en direction horizontale et en direction verticale en étant isolée des vibrations par rapport à la plaque de base ;
- un élément d'accouplement (5), qui définit le point de contact entre le piston (3) et la charge (4) et relie le piston (3) à la charge (4) ;
**caractérisé en ce que**
l'élément d'accouplement (5) est relié au piston (3) par une extension (10) traversant le piston (3) depuis le haut, d'une part, et à la charge (4) par une autre extension (11) allant vers la base et appliquée contre la charge (4), d'autre part, l'élément d'accouplement (5) étant espacé de la charge (4) d'au moins un quart de la longueur du piston.

2. Palier d'air à action verticale et horizontale selon la revendication 1, **caractérisé en ce que** l'élément d'accouplement (5) comporte une broche (6) reliée au piston (3), en particulier vissée dans le piston (3).

3. Palier d'air à action verticale et horizontale selon la revendication 1 ou 2, **caractérisé en ce que** l'accouplement du piston (3) et de la charge est espacée de la charge (4) d'au moins un tiers, préférentiellement de la moitié, et tout particulièrement des deux tiers de la longueur du piston.

4. Palier d'air à action verticale et horizontale selon l'une des revendications précédentes, **caractérisé en ce que** la broche (6) est sensiblement adjacente à la plaque de base.

5. Palier d'air à action verticale et horizontale selon l'une des revendications précédentes, **caractérisé en ce que** l'extension présente une forme sensiblement pyramidale ou conique.

6. Palier d'air à action verticale et horizontale selon l'une des revendications précédentes, **caractérisé en ce que** le diamètre de l'extension (10) diminue en direction de la base (12).

7. Palier d'air à action verticale et horizontale selon l'une des revendications précédentes, **caractérisé en ce que** le diamètre de l'autre extension (11) diminue en direction de la base (12).

8. Palier d'air à action verticale et horizontale selon l'une des revendications précédentes, **caractérisé en ce que** l'autre extension (11) est disposée dans l'extension (10) disposée contre le piston (3).
